(19) **Europäisches Patentamt**
**European Patent Office**
**Office européen des brevets**

(11) **EP 4 295 975 A1**

(12) **EUROPEAN PATENT APPLICATION**
published in accordance with Art. 153(4) EPC

(43) Date of publication:
**27.12.2023 Bulletin 2023/52**

(21) Application number: **22756244.4**

(22) Date of filing: **16.02.2022**

(51) International Patent Classification (IPC):
**B22F 7/08** (2006.01)          **B22F 9/00** (2006.01)
**C22C 9/00** (2006.01)          **H01L 23/373** (2006.01)
**H01L 21/52** (2006.01)          **B22F 1/00** (2022.01)
**B22F 1/102** (2022.01)

(52) Cooperative Patent Classification (CPC):
**B22F 1/00; B22F 1/102; B22F 7/08; B22F 9/00;
C22C 9/00; H01L 21/52; H01L 23/373**

(86) International application number:
**PCT/JP2022/006243**

(87) International publication number:
**WO 2022/176926 (25.08.2022 Gazette 2022/34)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **22.02.2021  JP 2021026575
22.02.2021  JP 2021026576**

(71) Applicant: **Mitsubishi Materials Corporation
Tokyo 100-8117 (JP)**

(72) Inventors:
• **IWATA, Koutarou**
**Naka-shi, Ibaraki 311-0102 (JP)**
• **YAMAGUCHI, Tomohiko**
**Naka-shi, Ibaraki 311-0102 (JP)**
• **NAKAYA, Kiyotaka**
**Naka-shi, Ibaraki 311-0102 (JP)**

(74) Representative: **Gille Hrabal
Partnerschaftsgesellschaft mbB
Patentanwälte
Brucknerstraße 20
40593 Düsseldorf (DE)**

(54) **BONDING PASTE, BONDED LAYER, BONDED BODY, AND METHOD FOR PRODUCING
BONDED BODY**

(57)     To suppress a decrease of strength, a bonding paste (10) includes a copper particle (12), a solvent (14), and an additive (16) composed of a phosphate ester. In the bonding paste (10), a content of the additive (16) is in the range of 0.5% to 3.0% by mass both inclusive relative to a total of the bonding paste (10).

FIG.1

EP 4 295 975 A1

**Description**

Field

The present invention relates to a bonding paste, a bonding layer, a bonded body, and a method for producing a bonded body.

Background

In general, a bonding material is used when bonding two or more components. For example, Patent Literature 1 describes the use of a solder as a bonding material. In recent years, the heat resistance of non-bonded components such as a semiconductor device has improved so that these are increasingly used in a high temperature environment in an automobile engine room, among others; accordingly, there is a case that a silver paste is used as the bonding material, as described in Patent Literature 2. The silver paste can be sintered under a relatively low temperature condition, and the melting point of the bonding layer formed after sintering is almost the same as that of silver. Therefore, the bonding layer consisting of this sintered silver paste has an excellent heat resistance and can be used stably in a high temperature environment and in a high electric current application. On the other hand, from the viewpoint of material cost, a copper paste is sometimes used as the bonding material, as illustrated, for example, in Patent Literature 3.

Citation List

Patent Literature

Patent Literature 1: Japanese Patent Application Laid-open No. 2004-172378
Patent Literature 2: Japanese Patent No. 6531547
Patent Literature 3: Japanese Patent Application Laid-open No. 2019-67515

Summary

Technical Problem

However, copper is easily oxidized, which may cause the decrease in a strength of the bonding layer composed of a sintered copper.
The present invention was made in view of the above circumstances; thus, an object of the present invention is to provide a bonding paste, a bonding layer, a bonded body, and a method for producing a bonded body; all of these being able to suppress the decrease in the strength.

Solution to Problem

To solve the problem above, a bonding paste of the present disclosure comprises: a copper particle; a solvent; and an additive including a phosphate ester, wherein a content of the additive is in a range of 0.5% to 3.0% by mass both inclusive relative to a total of the bonding paste.
To solve the problem above, a method for producing a bonded body of the present disclosure comprises bonding a first member and a second member together by using the bonding paste as a bonding layer to produce a bonded body.

Advantageous Effects of Invention

According to the present invention, it is possible to suppress the decrease in the strength even when the bonding is carried out in a non-reducing atmosphere.

Brief Description of Drawings

FIG. 1 is the schematic view of the bonding paste according to the first embodiment of the present invention.
FIG. 2 is the schematic view of the bonded body according to the first embodiment of the present invention.

FIG. 3 is the schematic view of the bonding paste according to the second embodiment of the present invention.
FIG. 4 is the schematic view of the bonded body according to the second embodiment of the present invention.
Description of Embodiments

The present invention will be described in detail below with reference to the drawings. Note that the present invention is not limited by the embodiments described below (hereinafter referred to as "embodiments"). In addition, the constituent elements in the following embodiments include those that can be readily assumed by a person ordinarily skilled in the art and those that are substantially identical, namely, those that are in the range of a so-called equivalent. Furthermore, the constituent elements disclosed in the following embodiments may be combined as appropriate. In addition, with regard to numerical values, rounded-off ranges are included.

(First Embodiment)

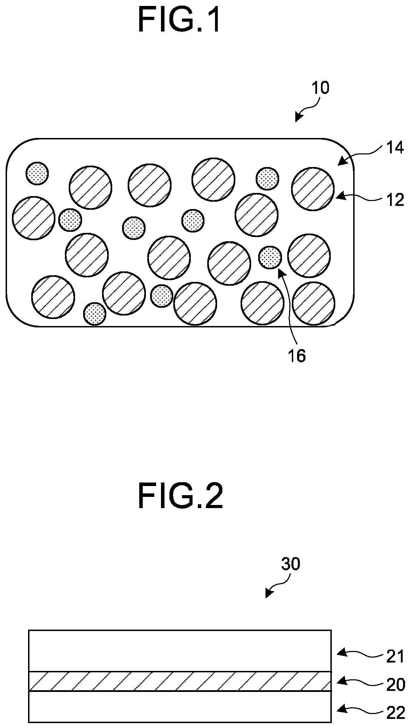

FIG. 1 is the schematic view of the bonding paste according to a first embodiment of the present invention. The bonding paste according to the first embodiment is used for bonding members to each other. As illustrated in FIG. 1, a bonding paste 10 according to the first embodiment includes a copper particle 12, a solvent 14, and an additive 16. FIG. 1 is the schematic view; so, the actual shape of the bonding paste 10 is not limited to the one that is illustrated in FIG. 1.

(Copper Particle)

The copper particle 12 has a BET diameter preferably in the range of 50 nm to 300 nm both inclusive. The BET diameter is the particle diameter calculated from the BET specific surface area and the true density of the copper particle determined by the BET method, assuming that the copper particle 12 is true spherical or cubic. Specifically, this value may be obtained by the method in Example to be described later.

When the BET diameter of the copper particle 12 is 50 nm or more, it is difficult to form a firm aggregate. Therefore, the surface of the copper particle 12 can be uniformly covered with the solvent 14. On the other hand, when the BET diameter of the copper particle 12 is 300 nm or less, the reaction area increases, resulting in enhancement of the sintering characteristics by heating, thereby enabling to form a firm bonding layer. The BET diameter of the copper particle 12 is preferably in the range of 80 nm to 200 nm both inclusive, and especially preferably in the range of 80 nm to 170 nm both inclusive.

The BET specific surface area of the copper particle 12 is preferably in the range of 2.0 m$^2$/g to 8.0 m$^2$/g both inclusive, more preferably in the range of 3.5 m$^2$/g to 8.0 m$^2$/g both inclusive, and especially preferably in the range of 4.0 m$^2$/g to 8.0 m$^2$/g both inclusive. The shape of the copper particle 12 is not limited to spherical, but can also be needle-like or flat plate-like.

It is preferable that the surface of the copper particle 12 be covered with an organic protective film, which is the film of an organic substance. Covering with the organic protective film suppresses the oxidation of the copper particle 12, thereby further lowering the deterioration in the sintering characteristics due to the oxidation of the copper particle 12. The organic protective film that covers the copper particle 12 is not formed by the solvent 14; so, it can be said that this is not originated from the solvent 14. It can also be said that the organic protective film that covers the copper particle 12 is not a film of the copper oxide formed by oxidation of copper.

The fact that the copper particle 12 is covered with the organic protective film can be confirmed by analysis of the surface of the copper particle 12 using the time-of-flight secondary ion mass spectrometry (TOF-SIMS). For this, in this embodiment, it is preferable that the ratio of the amount of the $C_3H_3O_3^-$ ion to the amount of the $Cu^+$ ion ($C_3H_3O_3^-$/$Cu^+$) detected by the analysis of the surface of the copper particle 12 using the time-of-flight secondary ion mass spectrometry be 0.001 or more. The $C_3H_3O_3^-$/$Cu^+$ ratio is more preferably in the range of 0.05 to 0.2 both inclusive. Herein, the surface of the copper particle 12 in this analysis refers to the surface of the copper particle 12 including the organic protective film that covers this particle (i.e., the surface of the organic protective film), not the surface of the copper particle 12 when the organic protective film is removed from the copper particle 12.

In the copper particle 12, a $C_3H_4O_2^-$ ion and $C_5$ and higher ions may be detected by the analysis of the surface thereof using the time-of-flight secondary ion mass spectrometry. The ratio of the detected amount of the $C_3H_4O_2^-$ ion to the detected amount of the $Cu^+$ ion ($C_3H_4O_2^-$/$Cu^+$) is preferably 0.001 or more. The ratio of the detected amount of the $C_5$ and higher ions to the detected amount of the $Cu^+$ ion ($C_5$ and higher ions/$Cu^+$) is preferably less than 0.005.

The $C_3H_3O_3^-$ ion, the $C_3H_4O_2^-$ ion, and the $C_5$ and higher ions detected by the analysis using the time-of-flight secondary ion mass spectrometry are originated from the organic protective film that covers the surface of the copper particle 12. Therefore, when the $C_3H_3O_3^-$/$Cu^+$ ratio and the $C_3H_4O_2^-$/$Cu^+$ ratio each are 0.001 or more, the surface of the copper particle 12 is less prone to be oxidized and the copper particle 12 is less prone to aggregate. When the $C_3H_3O_3^-$/$Cu^+$ ratio and the $C_3H_4O_2^-$/$Cu^+$ ratio are 0.2 or less, oxidation and agglomeration of the copper particle 12 can be suppressed without excessively deteriorating the sintering characteristics of the copper particle 12, and in addition, generation of decomposed gases from the organic protective film during heating can be suppressed, so that the bonding layer having fewer voids can be formed. In order to further enhance the oxidation resistance of the copper particle 12 during storage and the sintering characteristics at low temperature, the $C_3H_3O_3^-$/$Cu^+$ ratio and the $C_3H_4O_2^-$/$Cu^+$ ratio each are preferably in the range of 0.08 to 0.16 both inclusive. When the ratio $C_5$ and higher ions/$Cu^+$ is 0.005 times or more, a significant amount of the organic protective film having a comparatively high releasing temperature exists on the surface of the particle, resulting in insufficient sintering; thus, it is difficult to obtain a firm bonding layer. The ratio $C_5$ and higher ions/$Cu^+$ is preferably less than 0.003 times.

The organic protective film is originated preferably from citric acid. The method for producing the copper particle 12 covered with the organic protective film that is originated from citric acid will be described later. The amount of the organic protective film to cover the copper particle 12 relative to 100% by mass of the copper particle is preferably in the range of 0.5 to 2.0% by mass both inclusive, more preferably in the range of 0.8 to 1.8% by mass both inclusive, and still more preferably in the range of 0.8 to 1.5% by mass both inclusive. When the coverage amount of the organic protective film is 0.5% or more by mass, the copper particle 12 can be uniformly covered with the organic protective film, so that oxidation of the copper particle 12 can be suppressed more surely. When the coverage amount of the organic protective film is 2.0% or less by mass, it is possible to suppress the formation of a void in the sintered body of the copper particle (bonding layer) due to the gases that are generated by decomposition of the organic protective film caused by heating. The coverage amount of the organic protective film may be measured by using a commercially available instrument. For example, the differential thermal balance TG8120-SL (manufactured by RIGAKU Corp.) may be used to measure the coverage amount of the copper particle. In this case, for example, the copper particle having the water contained therein removed by freeze drying is used as the sample. The weight reduction rate measured when heated from 250°C to 300°C with the temperature raising rate of 10°C/min is defined as the coverage amount of the organic protective film. Here, the heating is carried out in a nitrogen gas (G2 grade) in order to suppress the oxidation of the copper particle. That is, coverage amount = (sample weight after measurement)/(sample weight before measurement) x 100 (wt%). The measurement is carried out three times for the copper particle in the same lot, and the arithmetic mean thereof may be used as the coverage amount.

It is preferable that 50% or more by mass of the organic protective film be decomposed upon heating the copper particle 12 in an inert gas atmosphere such as an argon gas at 300°C for 30 minutes. The organic protective film that is originated from citric acid generates a carbon dioxide gas, a nitrogen gas, an evaporated acetone gas, and a water vapor upon decomposition.

The copper particle 12 covered with the organic protective film that is originated from citric acid may be produced, for example, as follows. First, an aqueous copper citrate dispersion solution is prepared; then, to this aqueous copper citrate dispersion solution, a pH adjusting agent is added to adjust the pH thereof to the range of 2.0 to 7.5 both inclusive. Next, in an inert gas atmosphere, to this pH-adjusted aqueous copper citrate dispersion solution, a hydrazine compound is added as a reducing agent with the amount of 1.0 to 1.2 times equivalent both inclusive to the amount that can reduce the copper ion; then, they are mixed. The resulting mixture is heated in the temperature range of 60°C to 80°C both inclusive in an inert gas atmosphere, and then, this is kept in this state for a period of 1.5 to 2.5 hours both inclusive. By so doing, the copper ion that is eluted from the copper citrate is reduced to form the copper particle 12, and at the same time the organic protective film that is originated from citric acid is formed on the surface of the copper particle 12.

The aqueous copper citrate dispersion solution can be prepared by adding powdered copper citrate into pure water such as distilled water or ion-exchanged water in such a way that the concentration of the copper citrate may fall in the range of 25 to 40% by mass both inclusive, which is then followed by stirring with an agitator blade so as to uniformly disperse the particles. Illustrative examples of the pH adjusting agent include triammonium citrate, ammonium hydrogen citrate, and citric acid. Among these, triammonium citrate is preferable because this enables to conduct the pH adjustment mildly. The pH of the aqueous copper citrate dispersion solution is set to 2.0 or higher in order to facilitate the elution speed of the copper ion from the copper citrate and to promptly form the copper particle so that the intended fine copper particle 12 may be obtained. Also, the pH is set to 7.5 or lower in order to prevent conversion of the eluted copper ion to copper (II) hydroxide so that the yield of the copper particle 12 may be increased. By setting the pH to 7.5 or lower, the excessive reducing power of the hydrazine compound can be suppressed, so that the intended copper particle 12 can be readily obtained. It is preferable that the pH of the aqueous copper citrate dispersion solution be adjusted in the range of 4 to 6 both inclusive.

Reduction of the copper citrate by the hydrazine compound is carried out in an inert gas atmosphere. This is to prevent the oxidation of the copper ion that is eluted into the solution. Illustrative examples of the inert gas include a nitrogen gas and an argon gas. When reducing the copper citrate under an acidic condition, the hydrazine compound has advantages of producing no residues after the reduction reaction, being relatively safe, and being easy to handle, among other things. Illustrative examples of the hydrazine compound include hydrazine monohydrate, anhydrous hydrazine, hydrazine hydrochloride, and hydrazine sulfate. Among these hydrazine compounds, hydrazine monohydrate and anhydrous hydrazine, which do not contain components such as sulfur and chlorine that can become impurities, are preferable.

In general, the copper formed in an acidic solution of below pH 7 will dissolve. In this embodiment, however, the hydrazine compound, i.e., the reducing agent, is added to and mixed with the acidic solution of below pH 7 to produce the copper particle 12 in the resulting mixed solution. Therefore, the citric acid-originated component generated from the copper citrate promptly covers the surface of the copper particle 12, thereby suppressing dissolution of the copper particle 12. In order to facilitate the reduction reaction, it is preferable that the temperature of the aqueous copper citrate dispersion solution having the pH thereof adjusted as described above be set in the range of 50°C to 70°C both inclusive.

The resulting solution mixed with the hydrazine compound in an inert gas atmosphere is heated in the temperature range of 60°C to 80°C both inclusive, and then, this is kept at this temperature for a period of 1.5 to 2.5 hours both inclusive. Here, this heating is done in order to generate the copper particle 12, and at the same time to form the organic protective film so that the surface of the copper particle 12 thus generated may be covered with the film. Heating and keeping in the inert gas atmosphere are done in order to prevent the oxidation of the generated copper particle 12. The copper citrate, which is the starting raw material, usually contains about 35% by mass of copper. By adding the hydrazine compound as the reducing agent to the aqueous copper citrate dispersion solution containing roughly this amount of the copper component, and heating the resulting mixture at the temperature described above and then keeping the mixture for the time as described above, formations of the copper particle 12 and of the organic protective film on the surface of the copper particle 12 take place in a balanced manner, so that the copper particle 12 covered with the organic protective film, the amount of which is in the range of 0.5% to 2.0% by mass both inclusive relative to 100% by mass of the copper particle, can be obtained. When the heating temperature is lower than 60°C and the keeping time is less than 1.5 hours, the copper citrate is not completely reduced and the formation rate of the copper particle 12 is so slow that there is a risk that the amount of the organic protective film that covers the copper particle 12 may be too large. Also, when the heating temperature is higher than 80°C and the keeping time is longer than 2.5 hours, the formation rate of the copper particle 12 is so fast that the amount of the organic protective film that covers the copper particle 12 may be too small. Thus, the preferable heating temperature is in the range of 65°C to 75°C both inclusive, and the preferable keeping time is in the range of 2 to 2.5 hours both inclusive.

The copper particle 12 produced in the mixed solution is separated from the mixed solution in an inert gas atmosphere, for example, by solid-liquid separation using a centrifugation machine, which is then followed by drying by means of a freeze drying method or a vacuum drying method to obtain the copper particle 12 having the surface thereof covered with the organic protective film. The surface of the copper particle 12 is covered with the organic protective film, so that the particle is resistant to oxidation even when stored in an air until this is used as the bonding paste 10.

(Solvent)

The solvent 14 acts as a binder for the copper particle 12. The solvent 14 is an organic solvent. Any solvent 14 may be used; illustrative examples thereof include an alcohol-based solvent, a glycol-based solvent, an acetate-based solvent, a hydrocarbon-based solvent, and an amine-based solvent. Specific examples of the alcohol-based solvent include α-terpineol and isopropyl alcohol. Specific examples of the glycol-based solvent include ethylene glycol, diethylene glycol, and polyethylene glycol. Specific examples of the acetate-based solvent include butyl acetate carbitate. Specific examples of the hydrocarbon-based solvent include decane, dodecane, and tetradecane. Specific examples of the amine-based solvent include hexylamine, octylamine, and dodecylamine.

(Additive)

The additive 16 is a phosphate ester. Among organophosphate compounds, the ester that is formed by dehydration-condensation of a phosphoric acid with an alcohol may be called the phosphate ester. The average molecular weight of the phosphate ester used as the additive 16 is preferably in the range of 1000 to 2000 both inclusive, more preferably in the range of 1200 to 1800 both inclusive, and still more preferably in the range of 1400 to 1600 both inclusive. In the phosphate ester, when the average molecular weight is 1000 or more, the decomposition at room temperature may be suppressed and the storage stability may be improved; when 2000 or less, the decomposition and reaction at the target heating temperature (about 200°C to 350°C) may be possible. The average molecular weight here refers to the weight-average molecular weight. The average molecular weight may be measured, for example, by a size exclusion chromatography.

The phosphate ester to be used in the additive 16 may be any phosphate ester; illustrative examples thereof include laureth-n phosphate, oleth-n phosphate, and steareth-n phosphate (n is an integer). One, or two or more of them may be used as the additive 16.

(Bonding Paste)

In this embodiment, it is preferable that the bonding paste 10 contain no substances other than the copper particle 12, the solvent 14, and the additive 16 composed of the phosphate ester, except for unavoidable impurities. However, without limited by these, the bonding paste 10 may also contain an additive other than the copper particle 12, the solvent 14, and the additive 16 composed of the phosphate ester.

In the bonding paste 10, the content of the additive 16 relative to the total of the bonding paste 10 is, in terms of the mass ratio, in the range of 0.5% to 3.0% both inclusive, preferably in the range of 0.5% to 2.0% both inclusive, and more preferably in the range of 1.0% to 1.5% both inclusive. The content of the additive 16 in this range prevents the oxidation of the copper particle 12, and, as a result, the decrease in the strength of the bonding layer may be properly suppressed at the time when the members are bonded together using the bonding paste 10 in a non-reducing atmosphere.

In the bonding paste 10, the content of the solvent 14 relative to the total of the bonding paste 10 is, in terms of the mass ratio, in the range of 5% to 20% both inclusive, preferably in the range of 5% to 15% both inclusive, and more preferably in the range of 8% to 13% both inclusive. The content of the solvent 14 in this range allows proper dispersion of the copper particle 12.

(Method for Producing Bonding Paste)

The bonding paste 10 is produced by carrying out a mixing process at which the copper particle 12, the solvent 14, and the additive 16 are mixed. At this mixing process, the copper particle 12, the solvent 14, and the additive 16 are mixed such that the content of the additive 16 may be in the range of 0.5% to 3.0% by mass both inclusive relative to the total mass of the bonding paste 10. Also, at the mixing process, the copper particles 12, the solvent 14, and the additive 16 are mixed such that each of the content of solvent 14 and of the copper particle 12 relative to the total mass of the bonding paste 10 may be in the respective ranges described before. At the mixing process, the copper particle 12, the solvent 14, and the additive 16 may be mixed using a kneading machine. For example, a triple roll mill is used as the kneading machine.

(Method for Producing Bonded Body)

FIG. 2 is the schematic view of the bonded body according to the first embodiment. As illustrated in FIG. 2, in the first embodiment, a first member 21 and a second member 22 are bonded together using the bonding paste 10 as a bonding layer 20 to produce a bonded body 30. The first member 21 and the second member 22 may be arbitrary; so, for example, any one of the first member 21 and the second substrate may be a substrate and the other may be an electronic component. In other words, a semiconductor module in which a substrate and an electronic component are bonded by the bonding layer 20 may be produced as the bonded body 30. There is no particular restriction in the substrate. Illustrative examples thereof include an oxygen-free copper plate, a copper molybdenum plate, a high heat-dissipative insulating substrate (e.g., DCB (Direct Copper Bond)), and a substrate for mounting a semiconductor device such as an LED (Light Emitting Diode) package. Illustrative examples of the electronic component include an IGBT (Insulated Gate Bipolar Transistors), a diode, a Schottky barrier diode, a MOS-FET (Metal Oxide Semiconductor Field Effect Transistor), a thyristor, a logic, a sensor, an analog integrated circuit, an LED, a semiconductor laser, and a transmitter, among other semiconductor devices.

In this producing method, a coating layer forming process is carried out to form a coating layer by applying the bonding paste 10 to a surface of at least one of the first member 21 and the second member 22. There is no particular restriction in the application method. Illustrative examples thereof include a spin coating method, a metal masking method, a spray coating method, a dispenser coating method, a knife coating method, a slit coating method, an inkjet coating method, a screen printing method, an offset printing method, and a die coating method. Next, in order to volatilize the solvent in the paste, a preliminary heating process is carried out in the temperature range of 50°C to 150°C and for the period of 1 to 30 minutes. Next, a superimposing process is carried out at which process the first member 21 and the second member 22 are superimposed to each other via the coating layer.

Next, a heating process is carried out at which process the first member 21 and the second member 22 that have been superimposed to each other via the coating layer are heated. At the heating process, the heating is carried out at a prescribed temperature and for a prescribed period in a non-reducing atmosphere with applying a prescribed pressure to at least one of the superimposed first member 21 and second member 22. By carrying out the heating process, the copper particle 12 in the coating layer is sintered to form the bonding layer 20, thereby producing the bonded body 30 in which the first member 21 and the second member 22 are bonded together by the bonding layer 20.

The non-reducing atmosphere at the heating process means the state filled with a non-reducing gas, which can also be called an inert gas atmosphere filled with an inert gas. Examples of the non-reducing gas include nitrogen and a noble gas such as argon. For example, in this embodiment, the heating process may be carried out in a nitrogen atmosphere with the oxygen concentration of 1000 ppm. By carrying out the heating process in a non-reducing atmosphere, the use of the reducing gas is not necessary, so that the heating process may be carried out conveniently.

The prescribed pressure to be applied to at least one of the first member 21 and the second member 22 is preferably in the range of 0.5 MPa to 10 MPa both inclusive, more preferably in the range of 1 MPa to 5 MPa both inclusive, and still more preferably in the range of 2 MPa to 5 MPa both inclusive. The applied pressure that is set in this relatively low range suppresses a shape defect of the bonding layer 20 while properly bonding the first member 21 and the second member 22. The pressure here is applied in the direction of the first member 21 and the second member 22 to be pressed relative to each other via the coating layer.

The prescribed temperature, which is the heating temperature at the heating process, is preferably in the range of 200°C to 300°C both inclusive, more preferably in the range of 230°C to 300°C both inclusive, and still more preferably in the range of 250°C to 300°C both inclusive. When the heating temperature is set in this relatively low temperature range, the shape defect in the bonding layer 20 can be prevented from occurring with sintering the copper particle 12 properly.

The prescribed time, which is the heating time at the heating process, is preferably in the range of 1 to 10 minutes both inclusive, more preferably in the range of 1 to 5 minutes both inclusive, and still more preferably in the range of 1 to 3 minutes both inclusive. When the heating time is set in this range, the copper particle 12 can be properly sintered.

(Bonding Layer)

As explained above, the bonding layer 20 in this embodiment is formed by heating the bonding paste 10 to sinter the copper particle 12. The bonding layer 20 is located between the first member 21 and the second member 22 and bonds the first member 21 and the second member 22 together. The bonding layer 20 may also be said a sintered copper body. The sintered density of the copper particle in the bonding layer 20 is preferably in the range of 80% or more, more preferably in the range of 85% to 95% both inclusive, and still more preferably in the range of 85% to 90% both inclusive. When the sintered density is in this range, the electrical and thermal conductivities of the bonding layer 20 can be ensured. The sintered density is the ratio of the volume of the bonding layer 20 excluding the open and closed voids to the total volume of the bonding layer 20 including the open and closed voids. The sintered density was calculated from the equation described below, in which the randomly acquired SEM (Scanning Electron Microscope) image of the cross section of the bonding layer was divided into a particle portion and a void portion by binarizing at a magnification of 30000 using the image processing software (ImageJ, manufactured by National Institutes of Health, USA).

$$\text{Sintered density (\%) = (total area of particle portion/(total area of particle portion + total area of void portion)) x 100}$$

The bonding layer 20 also contains phosphorus. The phosphorus here refers to the phosphorus as an element and includes not only single body of phosphorus but also the phosphorus that is contained in any compound. In the bonding layer 20, the content of the phosphorous relative to the whole of the bonding layer 20 is, in terms of the mass ratio, preferably in the range of 10 ppm to 1000 ppm both inclusive, more preferably in the range of 50 ppm to 500 ppm both inclusive, and still more preferably in the range of 100 ppm to 500 ppm both inclusive. When the phosphorus content is in this range, the decrease in the strength of the bonding layer 20 can be suppressed, for example, even when formed in a non-reducing atmosphere. The phosphorus content may be measured by ICP-OES (Inductivity Coupled Plasma Optical Emission Spectrometer). In this embodiment, the phosphorus that is contained in the bonding layer 20 is originated from the phosphate ester included in the bonding paste 10.

The thickness of the bonding layer 20 is preferably in the range of 10 um to 200 um both inclusive, more preferably in the range of 20 um to 150 um both inclusive, and still more preferably in the range of 50 um to 100 um both inclusive. When the thickness is in this range, the bonding layer 20 can maintain a high heat dissipation property while mitigating the stress due to the difference in linear expansion coefficient between the members caused by temperature difference.

As described above, the bonding layer 20 according to this embodiment is the phosphorus-containing sintered copper having the sintered density of 80% or more. Because the bonding layer 20 has the sintered density of 80% or more, the decrease in the strength thereof can be suppressed. Furthermore, the oxidation of the copper particles 12 is suppressed by the phosphorus derivative (phosphate ester in this embodiment) included in the bonding layer 20; as a result, the decrease in the strength of the phosphorous-containing bonding layer 20 can be suppressed. The bonding layer 20 according to this embodiment is formed by heating the bonding paste 10 as described above, but the bonding layer 20 may be formed in any method as long as it meets the above characteristics.

(Effects)

As described above, the bonding paste 10 according to this embodiment includes the copper particle 12, the solvent 14, and the additive 16 composed of the phosphate ester, in which the content of the additive 16 is in the range of 0.5% to 3.0% by mass both inclusive relative to the total of the bonding paste 10. In the bonding paste 10 according to this embodiment, the oxidation of the copper particle 12 is suppressed by addition of the phosphate ester as the additive; as a result, the strength decrease of the bonding layer can be suppressed even when the members are bonded together in a non-reducing atmosphere.

The method for producing the bonding paste 10 according to this embodiment includes the step of forming the bonding paste 10 by mixing the copper particle 12, the solvent 14, and the additive 16 such that the content of the additive 16 may fall in the range of 0.5% to 3.0% by mass both inclusive relative to the total of the bonding paste 10. According to this production method, the addition of the phosphate ester as the additive suppresses the oxidation of the copper particle 12; as a result, the strength decrease of the bonding layer can be suppressed even when the members are bonded together in a non-reducing atmosphere.

In the method for producing the bonded body according to this embodiment, the bonded body is produced by bonding the first member and the second member together by using the bonding paste 10 as the bonding layer. According to this method, because the bonding paste 10 is used as the bonding layer, the strength decrease of the bonding layer can be suppressed even when the members are bonded together in a non-reducing atmosphere.

(Examples Relating to First Embodiment)

Next, Examples will be described.

(Example 1)

In Example 1, the copper particles having the BET diameter of 153 nm were prepared. The BET diameter was obtained as follows. Namely, the specific surface area of the copper particle was obtained by the BET method by measuring the amount of the nitrogen gas adsorbed by the copper particle using a specific surface area measuring instrument (QUANTACHROME AUTOSORB-1, manufactured by Quantachrome Instruments, Inc.). Then, using the obtained specific surface area S ($m^2/g$) and the density of the copper particle $\rho$ ($g/cm^3$), the BET diameter was calculated from the following formula.

$$BET\ diameter\ (nm)\ =\ 6000/(\rho(g/cm^3)\ \times\ S(m^2/g))$$

In Example 1, oleth-10 phosphate was prepared as the phosphate ester for the additive, and ethylene glycol was prepared as the solvent.

In Example 1, the copper particle, the additive, and the solvent were mixed to obtain the bonding paste having the additive content of 1% by mass, the solvent content of 10% by mass, with the remainder being the copper particle.

(Examples 2 to 10)

In Examples 2 to 10, the bonding paste was obtained by the same method as in Example 1, except that the BET diameter of the copper particle, the type of additive, the content of the additive, and the content of the solvent as described in Table 1 were used.

(Comparative Examples 1 to 3)

In Comparative Examples 1 to 3, the bonding pastes were obtained in the same manner as in Example 1, except that the type of the additive and the content of the additive as described in Table 1 were used.

(Evaluation)

The bonding paste obtained in each Example was used to produce the bonded body. Specifically, after a 3 mm aperture was formed in an oxygen-free copper plate, the bonding paste of each Example was printed to this plate using a metal mask having the thickness of 50 $\mu$m and a metal squeegee, which was then followed by drying on a hot plate at 90°C for 5 minutes. Next, a 2.5 mm x 2.5 mm silicon dummy chip having the back side thereof sputtered by gold with the thickness of 100 nm was put on the plate, which was then followed by heating for bonding in a nitrogen atmosphere at 250°C for 3 minutes while pressing at 5 MPa.

In the evaluation, the shear strength of the resulting bonded body (silicon dummy chip bonded with the oxygen-free copper plate) was measured. The shear strength of 40 MPa was judged "excellent", 20 MPa to 40 MPa both inclusive was judged "good", 10 MPa to 20 MPa both inclusive was judged "acceptable", and less than 10 MPa was judged "not acceptable". Herein, "acceptable", "good", and "excellent" were considered to have passed the test.

The shear strength of the resulting bonded body was measured by the method in accordance with JIS Z 3198-7 (Lead-free solder test method - part 7: solder joint shear test method for chip components). Specifically, a load was applied to the silicon dummy chip by using the tool of the bond tester (SERIES 4000, manufactured by Nordson DAGE Inc.); then, the load (maximum shear load) was measured at the time when the silicon dummy chip was peeled off from the copper bonding layer. The traveling speed of the tool was set to 50 um/sec, and the gap between the tool's front tip and the oxygen-free copper substrate was set to 50 um. The maximum shear load thereby obtained was Newton-converted, and then, this was divided by the area of the copper bonding layer (2.5 mm x 2.5 mm) to obtain the shear strength (unit: MPa). Seven bonded bodies were prepared, and the shear strength was measured for each of the bonded bodies. Each value described in Table 1 is the average of the shear strengths of the seven bonded bodies.

Table 1

| | Cu particle BET diameter (nm) | Additive | Molecular weight of additive | Amount of additive (wt%) | Amount of solvent (wt%) | Shear strength |
|---|---|---|---|---|---|---|
| Example 1 | 153 | Oleth-10 phosphate | 1492 | 1 | 10 | Excellent |
| Example 2 | 153 | Oleth-4 phosphate | 1492 | 1 | 10 | Good |
| Example 3 | 153 | Oleth-10 phosphate | 1492 | 0.5 | 10 | Acceptable |
| Example 4 | 153 | Oleth-10 phosphate | 1492 | 3 | 10 | Good |
| Example 5 | 153 | Oleth-10 phosphate | 1039 | 1 | 10 | Good |
| Example 6 | 153 | Oleth-10 phosphate | 1930 | 1 | 10 | Excellent |
| Example 7 | 153 | Oleth-10 phosphate | 1492 | 1 | 5 | Excellent |
| Example 8 | 153 | Oleth-10 phosphate | 1492 | 1 | 20 | Acceptable |
| Example 9 | 54 | Oleth-10 phosphate | 1492 | 1 | 10 | Excellent |
| Example 10 | 287 | phosphate | 1492 | 1 | 10 | Acceptable |
| Comparative Example 1 | 153 | Oleth-10 | 1203 | 1 | 10 | Not good |
| Comparative Example 2 | 153 | Oleth-10 phosphate | 1492 | 0.3 | 10 | Not good |
| Comparative Example 3 | 153 | Oleth-10 phosphate | 1492 | 3.5 | 10 | Not good |

In Table 1, the evaluation results for each Example are summarized. As can be seen in Table 1, the shear strengths in Examples have passed the test, indicating that the use of the bonding paste having the phosphate ester included therein with the amount in the range of 0.5% to 3.0% both inclusive in terms of the mass ratio can suppress the decrease of the strength even when the bonding is carried out in a non-reducing atmosphere. On the other hand, in Comparative Example 1, where the phosphate ester was not used as the additive, the shear strength was not good, indicating that the decrease of the strength cannot be avoided when the bonding is carried out in a non-reducing atmosphere. In Comparative Examples 2 and 3, where the content of the phosphate ester is outside the range of 0.5% to 3.0% both inclusive, the shear strength is also not good, indicating that the decrease of the strength cannot be suppressed when the bonding is carried out in a non-reducing atmosphere.

(Second Embodiment)

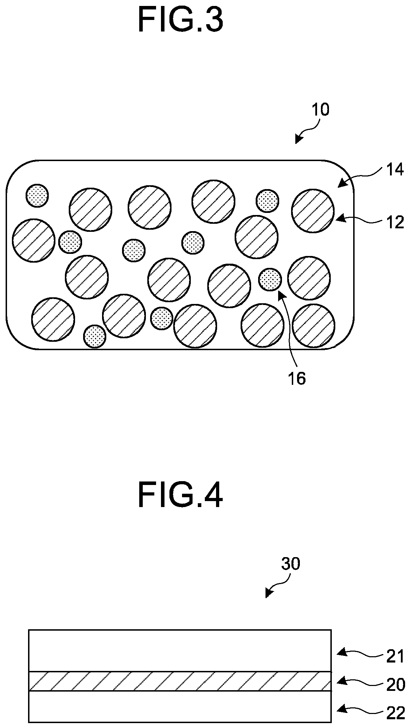

FIG. 3 is the schematic view of the bonding paste according to a second embodiment. The bonding paste according to the second embodiment is used for bonding members to each other. As illustrated in FIG. 3, the bonding paste 10 according to this embodiment includes the copper particle 12, the solvent 14, and the additive 16. FIG. 3 is the schematic view, so that the actual shape of the bonding paste 10 is not limited to the one that is illustrated in FIG. 3.

(Copper Particle)

The copper particle 12 has a BET diameter preferably in the range of 50 nm to 300 nm both inclusive. The BET diameter is the particle diameter calculated from the BET specific surface area and the true density of the copper particle determined by the BET method, assuming that the copper particle 12 is true spherical or cubic. Specifically, this value may be obtained by the method in Example to be described later.
When the BET diameter of the copper particle 12 is 50 nm or more, it is difficult to form a firm aggregate. Therefore, the surface of the copper particle 12 can be uniformly covered with the solvent 14. On the other hand, when the BET diameter of the copper particle 12 is 300 nm or less, the reaction area increases, resulting in enhancement of the sintering characteristics by heating, thereby enabling to form a firm bonding layer. The BET diameter of the copper particle 12 is preferably in the range of 80 nm to 200 nm both inclusive, and especially preferably in the range of 80 nm to 170 nm both inclusive.
The BET specific surface area of the copper particle 12 is preferably in the range of 2.0 $m^2/g$ to 8.0 $m^2/g$ both inclusive, more preferably in the range of 3.5 $m^2/g$ to 8.0 $m^2/g$ both inclusive, and especially preferably in the range of 4.0 $m^2/g$ to 8.0 $m^2/g$ both inclusive. The shape of the copper particle 12 is not limited to spherical, but can also be needle-like or flat plate-like.
It is preferable that the surface of the copper particle 12 be covered with an organic protective film, which is the film of an organic substance. Covering with the organic protective film suppresses the oxidation of the copper particle 12, thereby further lowering the deterioration in the sintering characteristics due to the oxidation of the copper particle 12. The organic protective film that covers the copper particle 12 is not formed by the solvent 14; so, it can be said that this is not originated from the solvent 14. It can also be said that the organic protective film that covers the copper particle 12 is not a film of the copper oxide formed by oxidation of copper.
The fact that the copper particle 12 is covered with the organic protective film can be confirmed by analysis of the surface of the copper particle 12 using the time-of-flight secondary ion mass spectrometry (TOF-SIMS). For this, in this embodiment, it is preferable that the ratio of the amount of the $C_3H_3O_3^-$ ion to the amount of the $Cu^+$ ion ($C_3H_3O_3^-$ /$Cu^+$) detected by the analysis of the surface of the copper particle 12 using the time-of-flight secondary ion mass spectrometry be 0.001 or more. The $C_3H_3O_3^-$/$Cu^+$ ratio is more preferably in the range of 0.05 to 0.2 both inclusive. Herein, the surface of the copper particle 12 in this analysis refers to the surface of the copper particle 12 including the organic protective film that covers this particle (i.e., the surface of the organic protective film), not the surface of the copper particle 12 when the organic protective film is removed from the copper particle 12.
In the copper particle 12, a $C_3H_4O_2^-$ ion and $C_5$ and higher ions may be detected by the analysis of the surface thereof using the time-of-flight secondary ion mass spectrometry. The ratio of the detected amount of the $C_3H_4O_2^-$ ion to the detected amount of the $Cu^+$ ion ($C_3H_4O_2^-$ /$Cu^+$) is preferably 0.001 or more. The ratio of the detected amount of the $C_5$ and higher ions to the detected amount of the $Cu^+$ ion ($C_5$ and higher ions/$Cu^+$) is preferably less than 0.005.
The $C_3H_3O_3^-$ ion, the $C_3H_4O_2^-$ ion, and the $C_5$ and higher ions detected by the analysis using the time-of-flight secondary ion mass spectrometry are originated from the organic protective film that covers the surface of the copper particle 12. Therefore, when the $C_3H_3O_3^-$/$Cu^+$ ratio and the $C_3H_4O_2^-$/$Cu^+$ ratio each are 0.001 or more, the surface of the copper particle 12 is less prone to be oxidized and the copper particle 12 is less prone to aggregate. When the $C_3H_3O_3^-$/$Cu^+$ ratio and the $C_3H_4O_2^-$/$Cu^+$ ratio are 0.2 or less, oxidation and agglomeration of the copper particle 12 can be suppressed without excessively deteriorating the sintering characteristics of the copper particle 12, and in addition, generation of decomposed gases from the organic protective film during heating can be suppressed, so that the bonding layer having fewer voids can be formed. In order to further enhance the oxidation resistance of the copper particle 12 during storage and the sintering characteristics at low temperature, the $C_3H_3O_3^-$ /$Cu^+$ ratio and the $C_3H_4O_2^-$/$Cu^+$ ratio each are preferably in the range of 0.08 to 0.16 both inclusive. When the ratio $C_5$ and higher ions/$Cu^+$ is 0.005 times or more, a significant amount of the organic protective film having a comparatively high releasing temperature exists on the surface of the particle, resulting in insufficient sintering; thus, it is difficult to obtain a firm bonding layer. The ratio $C_5$ and higher ions/$Cu^+$ is preferably less than 0.003 times.

The organic protective film is originated preferably from citric acid. The method for producing the copper particle 12 covered with the organic protective film that is originated from citric acid will be described later. The amount of the organic protective film to cover the copper particle 12 relative to 100% by mass of the copper particle is preferably in the range of 0.5 to 2.0% by mass both inclusive, more preferably in the range of 0.8 to 1.8% by mass both inclusive, and still more preferably in the range of 0.8 to 1.5% by mass both inclusive. When the coverage amount of the organic protective film is 0.5% or more by mass, the copper particle 12 can be uniformly covered with the organic protective film, so that oxidation of the copper particle 12 can be suppressed more surely. When the coverage amount of the organic protective film is 2.0% or less by mass, it is possible to suppress the formation of a void in the sintered body of the copper particle (bonding layer) due to the gases that are generated by decomposition of the organic protective film caused by heating. The coverage amount of the organic protective film may be measured by using a commercially available instrument. For example, the differential thermal balance TG8120-SL (manufactured by RIGAKU Corp.) may be used to measure the coverage amount of the copper particle. In this case, for example, the copper particle having the water contained therein removed by freeze drying is used as the sample. The weight reduction rate measured when heated from 250°C to 300°C with the temperature raising rate of 10°C/min is defined as the coverage amount of the organic protective film. Here, the heating is carried out in a nitrogen gas (G2 grade) in order to suppress the oxidation of the copper particle. That is, coverage amount = (sample weight after measurement)/(sample weight before measurement) x 100 (wt%) The measurement is carried out three times for the copper particle in the same lot, and the arithmetic mean thereof may be used as the coverage amount.

It is preferable that 50% or more by mass of the organic protective film be decomposed upon heating the copper particle 12 in an inert gas atmosphere such as an argon gas at 300°C for 30 minutes. The organic protective film that is originated from citric acid generates a carbon dioxide gas, a nitrogen gas, an evaporated acetone gas, and a water vapor upon decomposition.

The copper particle 12 covered with the organic protective film that is originated from citric acid may be produced, for example, as follows. First, an aqueous copper citrate dispersion solution is prepared; then, to this aqueous copper citrate dispersion solution, a pH adjusting agent is added to adjust the pH thereof to the range of 2.0 to 7.5 both inclusive. Next, in an inert gas atmosphere, to this pH-adjusted aqueous copper citrate dispersion solution, a hydrazine compound is added as a reducing agent with the amount of 1.0 to 1.2 times equivalent both inclusive to the amount that can reduce the copper ion; then, they are mixed. The resulting mixture is heated in the temperature range of 60°C to 80°C both inclusive in an inert gas atmosphere, and then, this is kept in this state for a period of 1.5 to 2.5 hours both inclusive. By so doing, the copper ion that is eluted from the copper citrate is reduced to form the copper particle 12, and at the same time the organic protective film that is originated from citric acid is formed on the surface of the copper particle 12.

The aqueous copper citrate dispersion solution can be prepared by adding powdered copper citrate into pure water such as distilled water or ion-exchanged water in such a way that the concentration of the copper citrate may fall in the range of 25 to 40% by mass both inclusive, which is then followed by stirring with an agitator blade so as to uniformly disperse the particles. Illustrative examples of the pH adjusting agent include triammonium citrate, ammonium hydrogen citrate, and citric acid. Among these, triammonium citrate is preferable because this enables to conduct the pH adjustment mildly. The pH of the aqueous copper citrate dispersion solution is set to 2.0 or higher in order to facilitate the elution speed of the copper ion from the copper citrate and to promptly form the copper particle so that the intended fine copper particle 12 may be obtained. Also, the pH is set to 7.5 or lower in order to prevent conversion of the eluted copper ion to copper (II) hydroxide so that the yield of the copper particle 12 may be increased. By setting the pH to 7.5 or lower, the excessive reducing power of the hydrazine compound can be suppressed, so that the intended copper particle 12 can be readily obtained. It is preferable that the pH of the aqueous copper citrate dispersion solution be adjusted in the range of 4 to 6 both inclusive.

Reduction of the copper citrate by the hydrazine compound is carried out in an inert gas atmosphere. This is to prevent the oxidation of the copper ion that is eluted into the solution. Illustrative examples of the inert gas include a nitrogen gas and an argon gas. When reducing the copper citrate under an acidic condition, the hydrazine compound has advantages of producing no residues after the reduction reaction, being relatively safe, and being easy to handle, among other things. Illustrative examples of the hydrazine compound include hydrazine monohydrate, anhydrous hydrazine, hydrazine hydrochloride, and hydrazine sulfate. Among these hydrazine compounds, hydrazine monohydrate and anhydrous hydrazine, which do not contain components such as sulfur and chlorine that can become impurities, are preferable.

In general, the copper formed in an acidic solution of below pH 7 will dissolve. In this embodiment, however, the hydrazine compound, i.e., the reducing agent, is added to and mixed with the acidic solution of below pH 7 to produce the copper particle 12 in the resulting mixed solution. Therefore, the citric acid-originated component generated from the copper citrate promptly covers the surface of the copper particle 12, thereby suppressing dissolution of the copper particle 12. In order to facilitate the reduction reaction, it is preferable that the temperature of the aqueous copper citrate dispersion solution having the pH thereof adjusted as described above be set in the range of 50°C to 70°C both inclusive.

The resulting solution mixed with the hydrazine compound in an inert gas atmosphere is heated in the temperature range of 60°C to 80°C both inclusive, and then, this is kept at this temperature for a period of 1.5 to 2.5 hours both inclusive. Here, this heating is done in order to generate the copper particle 12, and at the same time to form the organic protective film so that the surface of the copper particle 12 thus generated may be covered with the film. Heating and keeping in the inert gas atmosphere are done in order to prevent the oxidation of the generated copper particle 12. The copper citrate, which is the starting raw material, usually contains about 35% by mass of copper. By adding the hydrazine compound as the reducing agent to the aqueous copper citrate dispersion solution containing roughly this amount of the copper component, and heating the resulting mixture at the temperature described above and then keeping the mixture for the time as described above, formations of the copper particle 12 and of the organic protective film on the surface of the copper particle 12 take place in a balanced manner, so that the copper particle 12 covered with the organic protective film, the amount of which is in the range of 0.5% to 2.0% by mass both inclusive relative to 100% by mass of the copper particle, can be obtained. When the heating temperature is lower than 60°C and the keeping time is less than 1.5 hours, the copper citrate is not completely reduced and the formation rate of the copper particle 12 is so slow that there is a risk that the amount of the organic protective film that covers the copper particle 12 may be too large. Also, when the heating temperature is higher than 80°C and the keeping time is longer than 2.5 hours, the formation rate of the copper particle 12 is so fast that the amount of the organic protective film that covers the copper particle 12 may be too small. Thus, the preferable heating temperature is in the range of 65°C to 75°C both inclusive, and the preferable keeping time is in the range of 2 to 2.5 hours both inclusive.

The copper particle 12 produced in the mixed solution is separated from the mixed solution in an inert gas atmosphere, for example, by solid-liquid separation using a centrifugation machine, which is then followed by drying by means of a freeze drying method or a vacuum drying method to obtain the copper particle 12 having the surface thereof covered with the organic protective film. The surface of the copper particle 12 is covered with the organic protective film, so that the particle is resistant to oxidation even when stored in an air until this is used as the bonding paste 10.

(Solvent)

The solvent 14 acts as a binder for the copper particle 12. The solvent 14 is an organic solvent. Any solvent 14 may be used; illustrative examples thereof include an alcohol-based solvent, a glycol-based solvent, an acetate-based solvent, a hydrocarbon-based solvent, and an amine-based solvent. Specific examples of the alcohol-based solvent include $\alpha$-terpineol and isopropyl alcohol. Specific examples of the glycol-based solvent include ethylene glycol, diethylene glycol, and polyethylene glycol. Specific examples of the acetate-based solvent include butyl acetate carbitate. Specific examples of the hydrocarbon-based solvent include decane, dodecane, and tetradecane. Specific examples of the amine-based solvent include hexylamine, octylamine, and dodecylamine.

(Additive)

The additive 16 is a phosphate ester. Among organophosphate compounds, the ester that is formed by dehydration-condensation of a phosphoric acid with an alcohol may be called the phosphate ester. The average molecular weight of the phosphate ester used as the additive 16 is preferably in the range of 1000 to 2000 both inclusive, more preferably in the range of 1200 to 1800 both inclusive, and still more preferably in the range of 1400 to 1600 both inclusive. In the phosphate ester, when the average molecular weight is 1000 or more, the decomposition at room temperature may be suppressed and the storage stability may be improved; when 2000 or less, the decomposition and reaction at the target heating temperature (about 200°C to 350°C) may be possible. The average molecular weight here refers to the weight-average molecular weight. The average molecular weight may be measured, for example, by a size exclusion chromatography.

The phosphate ester to be used in the additive 16 may be any phosphate ester; illustrative examples thereof include laureth-n phosphate, oleth-n phosphate, and steareth-n phosphate (n is an integer). One, or two or more of them may be used as the additive 16.

(Bonding Paste)

In this embodiment, it is preferable that the bonding paste 10 contain no substances other than the copper particle 12, the solvent 14, and the additive 16 composed of the phosphate ester, except for unavoidable impurities. However, without limited by these, the bonding paste 10 may also contain an additive other than the copper particle 12, the solvent 14, and the additive 16 composed of the phosphate ester.

In the bonding paste 10, the content of the additive 16 relative to the total of the bonding paste 10 is, in terms of the mass ratio, in the range of 0.5% to 3.0% both inclusive, preferably in the range of 0.5% to 2.0% both inclusive, and more preferably in the range of 1.0% to 1.5% both inclusive. The content of the additive 16 in this range prevents the oxidation of the copper particle 12, and, as a result, the decrease in the strength of the bonding layer may be properly suppressed at the time when the members are bonded together using the bonding paste 10 in a non-reducing atmosphere.

In the bonding paste 10, the content of the solvent 14 relative to the total of the bonding paste 10 is, in terms of the mass ratio, in the range of 5% to 20% both inclusive, preferably in the range of 5% to 15% both inclusive, and more preferably in the range of 8% to 13% both inclusive. The content of the solvent 14 in this range allows proper dispersion of the copper particle 12.

(Method for Producing Bonding Paste)

The bonding paste 10 is produced by carrying out a mixing process at which the copper particle 12, the solvent 14, and the additive 16 are mixed. At this mixing process, the copper particle 12, the solvent 14, and the additive 16 are mixed such that the content of the additive 16 may be in the range of 0.5% to 3.0% by mass both inclusive relative to the total mass of the bonding paste 10. Also, at the mixing process, the copper particles 12, the solvent 14, and the additive 16 are mixed such that each of the content of solvent 14 and of the copper particle 12 relative to the total mass of the bonding paste 10 may be in the respective ranges described before. At the mixing process, the copper particle 12, the solvent 14, and the additive 16 may be mixed using a kneading machine. For example, a triple roll mill is used as the kneading machine.

(Method for Producing Bonded Body)

FIG. 4 is the schematic view of the bonded body according to the second embodiment. As illustrated in FIG. 4, in this embodiment, the first member 21 and the second member 22 are bonded together by using the bonding paste 10 as the bonding layer 20 to produce the bonded body 30. The first member 21 and the second member 22 may be arbitrary; so, for example, any one of the first member 21 and the second substrate may be a substrate and the other may be an electronic component. In other words, a semiconductor module in which a substrate and an electronic component are bonded by the bonding layer 20 may be produced as the bonded body 30. There is no particular restriction in the substrate. Illustrative examples thereof include an oxygen-free copper plate, a copper molybdenum plate, a high heat-dissipative insulating substrate (e.g., DCB (Direct Copper Bond)), and a substrate for mounting a semiconductor device such as an LED (Light Emitting Diode) package. Illustrative examples of the electronic component include an IGBT (Insulated Gate Bipolar Transistors), a diode, a Schottky barrier diode, a MOS-FET (Metal Oxide Semiconductor Field Effect Transistor), a thyristor, a logic, a sensor, an analog integrated circuit, an LED, a semiconductor laser, and a transmitter, among other semiconductor devices.

In this producing method, a coating layer forming process is carried out to form a coating layer by applying the bonding paste 10 to a surface of at least one of the first member 21 and the second member 22. There is no particular restriction in the application method. Illustrative examples thereof include a spin coating method, a metal masking method, a spray coating method, a dispenser coating method, a knife coating method, a slit coating method, an inkjet coating method, a screen printing method, an offset printing method, and a die coating method. Next, in order to volatilize the solvent in the paste, a preliminary heating process is carried out in the temperature range of 50°C to 150°C and for the period of 1 to 30 minutes. Next, a superimposing process is carried out at which process the first member 21 and the second member 22 are superimposed to each other via the coating layer.

Next, a heating process is carried out at which process the first member 21 and the second member 22 that have been superimposed to each other via the coating layer are heated. At the heating process, the heating is carried out at a prescribed temperature and for a prescribed period in a non-reducing atmosphere with applying a prescribed pressure to at least one of the superimposed first member 21 and second member 22. By carrying out the heating process, the copper particle 12 in the coating layer is sintered to form the bonding layer 20, thereby producing the bonded body 30 in which the first member 21 and the second member 22 are bonded together by the bonding layer 20.

The non-reducing atmosphere at the heating process means the state filled with a non-reducing gas, which can also be called an inert gas atmosphere filled with an inert gas. Examples of the non-reducing gas include nitrogen and a noble gas such as argon. For example, in this embodiment, the heating process may be carried out in a nitrogen atmosphere with the oxygen concentration of 1000 ppm. By carrying out the heating process in a non-reducing atmosphere, the use of the reducing gas is not necessary, so that the heating process may be carried out conveniently.

The prescribed pressure to be applied to at least one of the first member 21 and the second member 22 is preferably in the range of 0.5 MPa to 10 MPa both inclusive, more preferably in the range of 1 MPa to 5 MPa both inclusive, and still more preferably in the range of 2 MPa to 5 MPa both inclusive. The applied pressure that is set in this relatively low range suppresses a shape defect of the bonding layer 20 while properly bonding the first member 21 and the second member 22. The pressure here is applied in the direction of the first member 21 and the second member 22 to be pressed relative to each other via the coating layer.

The prescribed temperature, which is the heating temperature at the heating process, is preferably in the range of 200°C to 300°C both inclusive, more preferably in the range of 230°C to 300°C both inclusive, and still more preferably in the range of 250°C to 300°C both inclusive. When the heating temperature is set in this relatively low temperature range, the shape defect in the bonding layer 20 can be prevented from occurring with sintering the copper particle 12 properly.

The prescribed time, which is the heating time at the heating process, is preferably in the range of 1 to 10 minutes both inclusive, more preferably in the range of 1 to 5 minutes both inclusive, and still more preferably in the range of 1 to 3 minutes both inclusive. When the heating time is set in this range, the copper particle 12 can be properly sintered.

(Bonding Layer)

As explained above, the bonding layer 20 in this embodiment is formed by heating the bonding paste 10 to sinter the copper particle 12. The bonding layer 20 is located between the first member 21 and the second member 22 and bonds the first member 21 and the second member 22 together. The bonding layer 20 may also be said a sintered copper body. The sintered density of the copper particle in the bonding layer 20 is preferably in the range of 80% or more, more preferably in the range of 85% to 95% both inclusive, and still more preferably in the range of 85% to 90% both inclusive. When the sintered density is in this range, the electrical and thermal conductivities of the bonding layer 20 can be ensured. The sintered density is the ratio of the volume of the bonding layer 20 excluding the open and closed voids to the total volume of the bonding layer 20 including the open and closed voids. The sintered density was calculated from the equation described below, in which the randomly acquired SEM (Scanning Electron Microscope) image of the cross section of the bonding layer was divided into a particle portion and a void portion by binarizing at a magnification of 50000 using the image processing software (ImageJ, manufactured by National Institutes of Health, USA).

$$\text{Sintered density (\%)} = \text{(total area of particle portion/(total area of particle portion + total area of void portion))} \times 100$$

The bonding layer 20 also contains phosphorus. The phosphorus here refers to the phosphorus as an element and includes not only single body of phosphorus but also the phosphorus that is contained in any compound. In the bonding layer 20, the content of the phosphorous relative to the whole of the bonding layer 20 is, in terms of the mass ratio, preferably in the range of 100 ppm to 1000 ppm both inclusive, more preferably in the range of 100 ppm to 500 ppm both inclusive, and still more preferably in the range of 200 ppm to 500 ppm both inclusive. When the phosphorus content is in this range, the decrease in the strength of the bonding layer 20 can be suppressed, for example, even when formed in a non-reducing atmosphere. The phosphorus content may be measured by ICP-OES (Inductivity Coupled Plasma Optical Emission Spectrometer). In this embodiment, the phosphorus that is contained in the bonding layer 20 is originated from the phosphate ester included in the bonding paste 10.

The thickness of the bonding layer 20 is preferably in the range of 10 um to 200 um both inclusive, more preferably in the range of 20 um to 150 um both inclusive, and still more preferably in the range of 50 um to 100 um both inclusive. When the thickness is in this range, the bonding layer 20 can maintain a high heat dissipation property while mitigating the stress due to the difference in linear expansion coefficient between the members caused by temperature difference.

As described above, the bonding layer 20 according to this embodiment is the phosphorus-containing sintered copper having the sintered density of 80% or more. Because the bonding layer 20 has the sintered density of 80% or more, the decrease in the strength thereof can be suppressed. Furthermore, the oxidation of the copper particles 12 is suppressed by the phosphorus derivative (phosphate ester in this embodiment) included in the bonding layer 20; as a result, the decrease in the strength of the phosphorous-containing bonding layer 20 can be suppressed. The bonding layer 20 according to this embodiment is formed by heating the bonding paste 10 as described above, but the bonding layer 20 may be formed in any method as long as it meets the above characteristics.

(Effects)

As described above, the bonding layer 20 according to this embodiment is the sintered copper body that bonds members together, in which the sintered density is 80% or more with containing phosphorus. The bonding layer 20 according to this embodiment has the sintered density of 80% or more, and the oxidation of the copper particle 12 is suppressed by the derivative of phosphorus (phosphate ester in this embodiment); as a result, the decrease in the strength thereof can be suppressed.

The method for producing the bonded body 30 according to this embodiment includes a coating layer forming process, a superimposing process, and a heating process. At the coating layer forming process, the bonding paste 10, which contains copper particle 12, the solvent 14, and the additive 16, which is composed of the phosphate ester with the content of the additive 16 in the paste being in the range of 0.5% to 3.0% by mass both inclusive, is applied to a surface of at least one of the first member 21 and the second member 22 to form a coating layer. At the superposing process, the first member 21 and the second member 22 are superimposed via the coating layer. At the heating process, the first member 21 and the second member 22 that have been superimposed to each other via the coating layer are heated to form the bonded body 30. At the heating process, heating is carried out in a non-reducing atmosphere in the temperature range of 200°C to 300°C both inclusive and for the period of 1 to 10 minutes both inclusive with applying a pressure of 0.5 MPa to 10 MPa both inclusive to at least one of the first member 21 and the second member 22. According to this production method, when the bonding paste 10 having the phosphate ester added as an additive is used, the oxidation of the copper particle 12 can be suppressed; as a result, the decrease of the strength of the bonding layer 20 can be suppressed even when the members are bonded together in a non-reducing atmosphere.

(Examples Relating to Second Embodiment)

Next, Examples will be described.

(Example 11)

In Example 11, the copper particles having the BET diameter of 400 nm were prepared. The BET diameter was obtained as follows. Namely, the specific surface area of the copper particle was obtained by the BET method by measuring the amount of the nitrogen gas adsorbed by the copper particle using a specific surface area measuring instrument (QUANTACHROME AUTOSORB-1, manufactured by Quantachrome Instruments, Inc.). Then, using the obtained specific surface area S ($m^2$/g) and the density of the copper particle $\rho$ (g/$cm^3$), the BET diameter was calculated from the following formula.

$$\texttt{BET diameter (nm) = 6000/(\rho(g/cm}^3\texttt{) x S(m}^2\texttt{/g))}$$

In Example 11, oleth-10 phosphate was prepared as the phosphate ester for the additive, and ethylene glycol was prepared as the solvent.
In Example 11, the copper particle, the additive, and the solvent were mixed to obtain the bonding paste having the additive content of 1% by mass, the solvent content of 10% by mass, with the remainder being the copper particle.
In Example 11, the resulting bonding paste was used to produce the bonded body. Specifically, after a 3 mm aperture was formed in a copper plate, the bonding paste of each Example was printed to this plate using a metal mask having the thickness of 50 $\mu$m and a metal squeegee, and then, this was dried on a hot plate at 90°C for 5 minutes. Next, a 2.5 mm x 2.5 mm silicon dummy chip having the back side thereof sputtered by gold with the thickness of 100 nm was put on the plate, which was then heated for bonding in a nitrogen atmosphere at 250°C for 3 minutes while pressing at 5 MPa to form the bonding layer, so that the bonded body was obtained.
In Example 11, it was confirmed that the bonding layer included phosphorus. The inclusion of phosphorus was confirmed by ICP-OES.
In Example 11, the sintered density of the bonding layer was 91%. The sintered density was measured as follows
After the bonding layer was sealed with an epoxy resin, the bonding layer was cut horizontally against the thickness direction of the bonding layer. The cut surface of the bonding layer was polished mechanically and by using a cloth to expose the cross section surface of the bonding layer. Next, the cut surface of the bonding layer was observed with the magnification of 50000 using a scanning electron microscope (SEM). The obtained SEM image was binarized by using the image processing software (Image J, manufactured by the National Institutes of Health) to divide it into a particle portion and a void portion, and the sintered density was calculated using the following formula.

$$\texttt{Sintered density (\%) = (total area of particle portion/(total area of particle portion + total area of void portion)) x 100}$$

For the measurement of the sintered density, 10 SEM locations were randomly chosen. The value described in Table 2 is the average value of the sintered densities of the SEM images from 10 locations.

(Examples 12 to 17)

In Examples 12 to 17, the same method as in Example 11 was used, except that the bonding paste and the test condition were changed to those described in Table 2.

(Comparative Example 2)

In Comparative Example 2, the same method as in Example 11 was used, except that the bonding paste was changed as described in Table 2. The bonded body in Comparative Example 2 did not contain phosphorus, so that the sintered density was 76%.

(Evaluation)

In the evaluation, the shear strength of the resulting bonded body (silicon dummy chip bonded with the oxygen-free copper plate) was measured. The shear strength of 40 MPa was judged "excellent", 20 MPa to 40 MPa both inclusive was judged "good", 10 MPa to 20 MPa both inclusive was judged "acceptable", and less than 10 MPa was judged "not acceptable". Herein, "acceptable", "good", and "excellent" were considered to have passed the test.
The shear strength of the resulting bonded body was measured by the method in accordance with JIS Z 3198-7 (Lead-free solder test method - part 7: solder joint shear test method for chip components). Specifically, a load was applied to the silicon dummy chip by using the tool of the bond tester (SERIES 4000, manufactured by Nordson DAGE Inc.); then, the load (maximum shear load) was measured at the time when the silicon dummy chip was peeled off from the copper bonding layer. The traveling speed of the tool was set to 50 $\mu$m/sec, and the gap between the tool's front tip and the oxygen-free copper substrate was set to 50 um. The maximum shear load thereby obtained was Newton-converted, and then, this was divided by the area of the copper bonding layer (2.5 mm x 2.5 mm) to obtain the shear strength (unit: MPa). Seven bonded bodies were prepared, and the shear strength was measured for each of the bonded bodies. The value described in Table 2 is the average of the shear strengths of the 7 bonded bodies.

Table 2

| | Bonding paste | | | | | Test condition | | | | Bonding layer | | | Evaluation result |
|---|---|---|---|---|---|---|---|---|---|---|---|---|---|
| | Cu particle BET diameter (nm) | Additive | Molecular weight of additive | Amount of additive (mass%) | Amount of solvent (mass%) | Printing thickness ($\mu$m) | Pressure at heating (Mpa) | Heating temp. (°C) | Heating time (min-utes) | Thickness ($\mu$m) | Phosphorous (ppm) | Sintered density (%) | Shear strength |
| Example 11 | 153 | Oleth-10 phosphate | 1492 | 1 | 10 | 50 | 5 | 250 | 3 | 25 | 270 | 91 | Excellent |
| Example 12 | 153 | Oleth-10 phosphate | 1492 | 1 | 10 | 50 | 1 | 250 | 1 | 34 | 280 | 84 | Good |
| Example 13 | 153 | Oleth-10 phosphate | 1492 | 1 | 10 | 50 | 10 | 300 | 10 | 16 | 270 | 97 | Excellent |
| Example 14 | 153 | Oleth-10 phosphate | 1492 | 0.5 | 10 | 50 | 5 | 250 | 3 | 31 | 110 | 88 | Good |
| Example 15 | 153 | Oleth-10 phosphate | 1492 | 3 | 10 | 50 | 5 | 250 | 3 | 21 | 920 | 94 | Excellent |
| Example 16 | 153 | Oleth-10 phosphate | 1492 | 1 | 10 | 300 | 5 | 250 | 3 | 185 | 290 | 91 | Excellent |
| Example 17 | 153 | Oleth-10 phosphate | 1492 | 1 | 10 | 20 | 5 | 250 | 3 | 13 | 240 | 91 | Good |
| Comparative Example 2 | 153 | Oleth-10 | 1203 | 1 | 10 | 50 | 5 | 250 | 3 | 31 | 0 | 76 | Not good |

In Table 2, the evaluation results for each Example are summarized. As can be seen in Table 2, the shear strength has passed the test in Examples, indicating that the use of the bonded body that contains phosphorus with the sintered density of 80% or more can suppress the decrease of the strength. On the other hand, it can be seen that in Comparative Example 2, the use of the bonded body not containing phosphorus with the sintered density of less than 80% cannot suppress the decrease of the strength.

The embodiments according to the present invention were described above; however, the embodiments are not limited by the contents of these embodiments. In addition, the constituent elements described above include those that can be readily assumed by a person ordinarily skilled in the art and those that are substantially identical, i.e., in the range of a so-called equivalent. Furthermore, the constituent elements described above may be combined as appropriate. Furthermore, various omissions, substitutions, or modifications of the constituent elements described above may be made as long as such does not depart from the gist of the embodiments described above.

Reference Signs List

10    Bonding paste
12    Copper particle
14    Solvent
16    Additive
20    Bonding layer
21    First member
22    Second member
30    Bonded body

## Claims

1. A bonding paste comprising:

   a copper particle;
   a solvent; and
   an additive including a phosphate ester, wherein
   a content of the additive is in a range of 0.5% to 3.0% by mass both inclusive relative to a total of the bonding paste.

2. The bonding paste according to claim 1, wherein an average molecular weight of the phosphate ester is in a range of 1000 to 2000 both inclusive.

3. The bonding paste according to claim 1 or 2, wherein a content of the solvent is in a range of 5% to 20% by mass both inclusive relative to a total of the bonding paste.

4. The bonding paste according to any one of claims 1 to 3, wherein a surface of the copper particle is covered with an organic protective film.

5. The bonding paste according to any one of claims 1 to 4, wherein a BET diameter of the copper particle is in a range of 50 nm to 300 nm both inclusive.

6. A method for producing a bonded body, the method comprising bonding a first member and a second member together by using the bonding paste according to any one of claims 1 to 5 as a bonding layer to produce a bonded body.

7. A bonding layer comprising a sintered body of copper to bond members together, wherein
   the bonding layer has a sintered density of 80% or more and contains phosphorous.

8. The bonding layer according to claim 7, wherein a content of the phosphorus relative to a total of the bonding layer is in a range of 100 ppm to 1000 ppm by mass both inclusive.

9. The bonding layer according to claim 7 or 8, wherein a thickness of the bonding layer is in a range of 10 um to 200 um both inclusive.

**10.** A bonded body comprising:

> a first member;
> a second member; and
> a bonding layer according to any one of claims 7 to 9, disposed between the first member and the second member.

**11.** The bonded body according to claim 10, wherein the first member is a substrate and the second member is an electronic component to constitute a semiconductor module.

**12.** A method for producing a bonded body, the method comprising:

> a coating layer forming process at which a bonding paste including a copper particle, a solvent, and an additive including a phosphate ester with a content of the additive in the bonding paste being in a range of 0.5% to 3.0% by mass both inclusive is applied to a surface of at least one of a first member and a second member to form a coating layer;
> a superimposing process at which the first member and the second member are superimposed via the coating layer; and
> a heating process at which the first and second members superimposed via the coating layer are heated to form a bonded body, wherein
> at the heating process, the heating is carried out in a temperature range of 200°C to 300°C both inclusive and for a period of 1 minute to 10 minutes both inclusive in a non-reducing atmosphere with applying a pressure of 0.5 MPa to 10 MPa both inclusive to at least one of the first member and the second member.

# FIG.1

# FIG.2

# FIG.3

# FIG.4

## INTERNATIONAL SEARCH REPORT

| International application No. |
|---|
| **PCT/JP2022/006243** |

**A. CLASSIFICATION OF SUBJECT MATTER**

*B22F 7/08*(2006.01)i; *B22F 9/00*(2006.01)i; *C22C 9/00*(2006.01)i; *H01L 23/373*(2006.01)i; *H01L 21/52*(2006.01)i; *B22F 1/00*(2022.01)i; *B22F 1/102*(2022.01)i

FI: B22F9/00 B; B22F1/00 L; B22F1/102; H01L21/52 E; C22C9/00; H01L23/36 M; H01L21/52 B; B22F7/08 C

According to International Patent Classification (IPC) or to both national classification and IPC

**B. FIELDS SEARCHED**

Minimum documentation searched (classification system followed by classification symbols)

B22F7/08; B22F9/00; C22C9/00; H01L23/373; H01L21/52; B22F1/00; B22F1/102

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2014-111800 A (NIPPON HANDA KK) 19 June 2014 (2014-06-19)<br>claims, paragraphs [0109], [0194]-[0198], tables 16-17 | 1, 3-12 |
| X | JP 2018-59192 A (DOWA ELECTRONICS MATERIALS CO) 12 April 2018 (2018-04-12)<br>claims, paragraphs [0021]-[0022], [0029]-[0061] | 1, 3-12 |
| X | WO 2016/031860 A1 (ISHIHARA SANGYO KAISHA) 03 March 2016 (2016-03-03)<br>claims, paragraphs [0003], [0009], [0012], [0087]-[0127], table 3 | 7-11 |
| A | JP 2014-225338 A (ISHIHARA CHEMICAL CO LTD) 04 December 2014 (2014-12-04)<br>abstract, claims | 1-12 |
| A | JP 2020-59914 A (MITSUBISHI MATERIALS CORP) 16 April 2020 (2020-04-16)<br>claims, paragraphs [0030], [0041]-[0042]-[0080] | 3-5,12 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **15 April 2022** | **26 April 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2022/006243**

| Patent document cited in search report | | | Publication date (day/month/year) | Patent family member(s) | Publication date (day/month/year) |
|---|---|---|---|---|---|
| JP | 2014-111800 | A | 19 June 2014 | (Family: none) | |
| JP | 2018-59192 | A | 12 April 2018 | US 2019/0283129 A1 claims, paragraphs [0022]-[0023], [0029]-[0061] WO 2018/062220 A1 CN 109789482 A KR 10-2019-0064605 A | |
| WO | 2016/031860 | A1 | 03 March 2016 | US 2017/0252801 A1 claims, paragraphs [0003], [0030], [0185]-[0219], table 3 KR 10-2017-0046164 A CN 106715009 A | |
| JP | 2014-225338 | A | 04 December 2014 | US 2016/0007455 A1 abstract, claims WO 2014/185102 A1 CN 105210155 A KR 10-2015-0138332 A | |
| JP | 2020-59914 | A | 16 April 2020 | WO 2020/071432 A1 CN 112689545 A KR 10-2021-0068468 A | |

Form PCT/ISA/210 (patent family annex) (January 2015)

**EP 4 295 975 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004172378 A
- JP 6531547 B
- JP 2019067515 A